# EUROPEAN PATENT SPECIFICATION

(11) **EP 2 345 312 B1**
(45) Date of publication and mention of the grant of the patent: **30.05.2018**
(21) Application number: 09743959.0
(22) Date of filing: 22.10.2009
(51) Int. Cl.: H05H 1/24, H01J 37/32

(54) **APPARATUS AND METHOD FOR TREATING AN OBJECT BY PLASMA**
VORRICHTUNG UND VERFAHREN ZUR BEHANDLUNG EINES OBJEKTS DURCH PLASMA
APPAREIL ET PROCÉDÉ POUR TRAITER UN OBJET PAR PLASMA

(30) Priority: 23.10.2008 EP 08167402
(43) Date of publication of application: 20.07.2011
(73) Proprietor: Nederlandse Organisatie voor toegepast- natuurwetenschappelijk onderzoek TNO, 2595 DA 's-Gravenhage (NL)
(72) Inventor: CREYGHTON, Yves Lodewijk Maria, NL-2611 VX Delft (NL); SIMOR, Marcel, NL-2718 GV Zoetermeer (NL)
(74) Representative: V.O.
(86) International application number: PCT/NL2009/050639
(87) International publication number: WO 2010/047593

(56) References cited:
- EP-A- 1 750 294
- WO-A-2008/082297
- US-A1- 2003 192 645
- US-A1- 2005 016 684
- US-A1- 2005 150 602
- US-A1- 2006 086 461

## Description

The invention relates to an apparatus for treating an object using a plasma process, comprising a supporting structure for supporting the object, and an electrode structure for generating the plasma process.

Such an apparatus is e.g. known from the International patent publication WO 2008 / 082297.

Atmospheric pressure plasma (APP) can be effectively used for surface modification of various materials. For example adhesion properties of textile materials can be enhanced in a continuous high speed process. Plasma deposition of thin coatings, eventually comprising submicron particles, is very suitable to add functional properties to existing high performance textile materials without losing the original properties. Plasma deposited thin coatings may be used to add or improve one or more of the following properties: antimicrobial, hydrophobic, oleophobic, hydrophilic, flame retardant, heat resistant, heat absorbing, fluorescent, electrical conducting, ballistic impact, puncture and knife resistant.

Though technical solutions for low pressure plasma treatment are available, APP offers significant advantages by reducing the down time for unloading and loading of substrate materials (e.g. textiles, foils, paper, fibers) and chemical precursor gases. Further development of APP technology may replace existing wet chemical processes with large substrate area processing capability. Major savings of processing time, energy, raw materials, waste and related costs may be achieved.

The development of APP technology enables plasma applications which so far have been unfeasible or very unpractical in vacuum. Examples are disinfection, sterilization, and decontamination of large surface areas such as floors and walls, in line sterilization of packaging articles and medical instruments. Medical treatment including disinfection of human skin and wound treatment represent another application area.

A frequently used type of APP is the Dielectric Barrier Discharge (DBD). In DBD electrode configurations at least one or both electrodes are electrically isolated from the plasma by means of a dielectric layer. DBD plasma is operated using an alternating or repetitively pulsed voltage. The power density of DBD plasma (Joules/cm3) can be easily controlled by varying the applied frequency, or voltage or gas residence time conditions. At low power densities, low process gas temperatures can be maintained and thus treatment of heat-sensitive materials is made possible.

DBD plasma is widely applied in ozone generators, surface modification of plastic foils and textile materials, UV excimer lamps and plasma display panels.

A particular type of DBD is known as Surface Dielectric Barrier Discharge (SDBD). In contrast to Volume Dielectric Barrier Discharges (VDBD) where the plasma develops in a gas gap in between two surfaces (at least one is covered by a dielectric layer), in SDBD electrode configurations the electrodes are integrated with a single solid dielectric structure thereby creating a plasma which is concentrated on the dielectric surface of this structure.

The discharge structure consists of streamers (also called micro-discharges), mainly developing on the dielectric in the same direction parallel to each other. In order to sustain SDBD plasma continuously, alternating polarity voltage or a series of pulses must be applied to the electrodes. During each change of the voltage-time gradient dV/dt streamers of the opposite polarity are generated on the dielectric. The streamer length for negative dV/dt is shorter than for positive dV/dt. As result of the repulsive Coulomb force between streamers having the same excess charge, the branches never overlap each other. There appears to be an approximate linear relationship between the peak value of the applied voltage and streamer length. The physical properties of SDBD plasma of known electrode configurations have been widely studied through experiment and numerical modelling.

A higher homogeneity in Dielectric Barrier Discharges can be defined as (a) a higher number of streamers per unit volume and (b) the decrease of differences in both structure and energy content between various streamers. When injected power in SDBD plasma is increased either by voltage or frequency, the homogeneity of the SDBD plasma is increased. This phenomenon is one of the most distinctive properties of SDBD plasma compared to VDBD plasma. In SDBD plasma, the increase of power results in a higher streamer number density, more branched streamers and a more balanced distribution of energy among streamers. On the contrary, in VDBD plasma an increase of power density by increase of voltage or frequency results in a reduced number of more intense streamers, causing less homogeneity in space and less stability in time of the plasma structure.

When plasma polymerization is applied, deposits can be formed on the SDBD treating surface. Moreover, plasma may create particles (dust) in the gas phase that may also be deposited on electrodes. Deposition on electrodes may also be caused by abrasion of substrate material or abrasion/erosion of electrodes in a plasma surface activation process without polymerization (in a plasma surface activation process). There is a strong need for an apparatus avoiding deposition of materials on the electrode/dielectric surface. Further, there is a need for an apparatus removing deposits continuously or periodically.

It is an object of the invention to provide an apparatus according to the preamble, wherein at least one of the disadvantages identified above is reduced. In particular, the invention aims at obtaining an apparatus according to the preamble wherein deposition of materials on the electrode/dielectric surface is avoided. Thereto, an apparatus is provided as defined in claim 1.

By separately flowing materials towards the object via multiple gas flow paths wherein downstream sections of at least two gas flow paths of the multiple gas flow paths substantially coincide, the location of generated particles, e.g. polymer forming compounds and/or radicals, can be determined more accurately and more in the vicinity of the object to be treated, thereby counteracting that electrode and/or dielectric surfaces are deposited with material. The desired particles are generated in the region where the downstream gas flow paths sections coincide. Further, a more uniform and/or more efficient deposition of particles on an object to be treated, can be obtained by localizing the coinciding downstream gas flow path sections near the object. As a result, the life time of e.g. radicals is more efficiently exploited.

In general, a first material can be flown in a first gas flow path and a second material in a second gas flow path. Gaseous particles can be added and solid and/or liquid particles can be added using a solid/liquid particle spray in a gas stream and/or on the surface of the object to be treated. The first material preferentially comprises one or more gaseous compounds with functional chemical groups providing specific functions such as for example antimicrobial activity, UV absorbance, hydrophobicity, conductivity, fluorescence or colour. The second material is preferably electropositive and does not form, or very slowly, a polymer in plasma conditions. The second material may generate active plasma species, in particular ions, radicals such as N and H, metastable excited electronic states of nitrogen and vibrational excited states of nitrogen. As a result, efficient transport of reactive plasma species to the second gas material and/or the surface is realized. Further, deposition on SDBD electrode surfaces is counteracted. Also, polymerization without loosing functionality of monomers is obtained because the average energy of electrons is reduced in the downstream sections of gas flow paths. Further, bonding of functional submicron particles to the surface is possible by means of embodiment of said particles in a polymer coating.

As a first example, the first material comprises polymer forming monomer with antimicrobial functional groups while the second material comprises N₂, H₂, Ar or He. Examples of polymer forming monomers with antimicrobial functional groups are compounds containing a quaternary ammonium moiety. In order to produce an antimicrobial coating, dimethylaminoethyl-methacrylate can be used as a first material in a first gas flow, while the second gas comprises bromoheptane.

As a second example, the first material comprises pre-deposited, e.g. liquid aerosol mist, powder, AM compounds on substrate while the second material comprises N₂, H₂, Ar or He.

As a third example, the first material comprises poly-di-methyl-aminomethyl-styrene and the second material comprises di-tert-amyl-peroxide. The first, second and third examples result in a polymerization layer with AM functionality.

In a fourth example, the first material comprises a polymer forming monomer. The second material comprises solid particles which have been dispersed in an initiator gas, e.g. N₂ or Ar. Polymer layers containing functional solid particles can be deposited. Multi-functionalities are achieved by combination of the properties of the polymer and catalytic and/or morphological properties of the polymer embedded particles, e.g. combined antimicrobial and super-hydrophobic layers.

In a fifth example, the first and second material is replaced by liquid and/or gaseous monomers, where the first and/or second material contains solid particles, leading to the deposition of elastomeric bonded solid particles. An increased energy transfer in between yarns of anti-ballistic woven aramide materials is obtained. Further, a deposited polymer coating containing metal and or ceramic particles will provide improved knife, stab, and puncture resistance.

In a sixth example, the first material comprises metal-organic compounds, e.g. trimetylaluminium (TMA) while the second material comprises Argon or Helium, leading to AlOx gas barrier coatings.

In a seventh example, the first material comprises vaporized metal-organic compounds and water or oxygen. The second material comprises a noble gas, such as He or Ar, with a reducing compound, e.g. H₂, leading to conductive coatings on flexible substrates, conductive polymer coatings, transparent conductive oxides (TCO), various applications including TCO for photovoltaic layers on flexible substrates.

In an eight example, the first material is replaced by SiH4 (silane) leading to SiOx layers for photovoltaic layers on flexible substrates.

In a ninth example, the first material comprises water, disinfectants containing halogens (chlorine or fluorine) such as chloroxylenol (chlorodimethylphenol) (Dettol) and trichlorohydroxydiphenyl ether (Triclosan powder). Those materials can be added in liquid spray/powder to gas or predeposited on the substrate. As a result, low temperature disinfection (or sterilization) of articles or surfaces is available. Human skin, food and medical packaging foil materials, medical instrumentation, floors and walls can be disinfected, sterilized or cleaned. Plasma initiated gas renders disinfectants more effective, i.e. lower quantities needed, less adverse effects, reduced treatment time are obtained. Micro-organisms are further weakened by synergistic combined chemical and plasma treatment effects. Cleaning or regeneration of air filter material for particulate matter and gas adsorption e.g. active carbon, zeolites, ceramic foam, glass fibre based is also possible. Examples of pollutants which are removed, are dust, smoke, odours, volatile organic compounds.

As a tenth example, the first gas comprises acetylene (C2H2) and the second gas comprises ammonia (NH3). With the admixture of ammonia, an etching process is introduced during plasma polymerisation of acetylene. As a result, a nanoporous, highly cross linked coating is obtained containing accessible functional groups. Further, the formation of a polymer coating on the SDBD electrodes is counteracted.

In an eleventh example, the proper selection of the first gas containing a macromolecular monomer and the second gas containing catalyst particles is used for the deposition of multifunctional hyperbranched polymer coating.

By the term "plasma" is meant a partially ionized gas that represents a chemically active environment comprising activated species such as electrons, ions, vibrational and electronic excited states, radicals, metastables and photons. The proposed apparatus is preferably applied using gas flows at approximately atmospheric pressure. However, gas flows at reduced pressure or super atmospheric pressure, in the range 0.1-2 x 10e5 Pa (0.1-2 bar) can be effectively applied as well.

Further, the invention relates to a method as defined in claim 13.

Other advantageous embodiments according to the invention are described in the following claims.

By way of example only, embodiments of the present invention will now be described with reference to the accompanying figures in which
Fig. 1 shows a schematic side view of a first embodiment of an apparatus according to the invention;
Fig. 2 shows a schematic side view of second embodiment of an apparatus according to the invention;
Fig. 3 shows a schematic side view of third embodiment of an apparatus according to the invention;
Fig. 4 shows a schematic side view of fourth embodiment of an apparatus according to the invention;
Fig. 5 shows a schematic side view of fifth embodiment of an apparatus according to the invention;
Fig. 6 shows a schematic view of a first embodiment of a dielectric barrier discharge plasma unit used in the apparatus shown in Figure 1;
Fig. 7 shows a schematic view of a second embodiment of a dielectric barrier discharge plasma unit used in the apparatus shown in Figure 1;
Fig. 8 shows a schematic view of a third embodiment of a dielectric barrier discharge plasma unit used in the apparatus shown in Figure 1;
Fig. 9a shows a schematic view of a first embodiment of two dielectric barrier discharge plasma units used in the apparatus shown in Figure 1;
Fig. 9b shows a schematic view of a second embodiment of two dielectric barrier discharge plasma units used in the apparatus shown in Figure 1;
Fig. 9c shows a schematic view of a third embodiment of two dielectric barrier discharge plasma units used in the apparatus shown in Figure 1;
Fig. 10a shows a schematic view of a fourth embodiment of two dielectric barrier discharge plasma units used in the apparatus shown in Figure 1;
Fig. 10b shows a schematic view of a fifth embodiment of two dielectric barrier discharge plasma units used in the apparatus shown in Figure 1;
Fig. 10c shows a schematic view of a sixth embodiment of two dielectric barrier discharge plasma units used in the apparatus shown in Figure 1;
Fig. 11 shows a schematic view of a dielectric barrier discharge plasma unit manufacturing process;
Fig. 12 shows a schematic side view of sixth embodiment of an apparatus according to the invention;
Fig. 13 shows a schematic view of a dielectric barrier discharge plasma unit used in the apparatus shown in Figure 12; and
Fig. 14 shows a schematic view of a series of dielectric barrier discharge plasma units used in the apparatus shown in Figure 12.

The figures are merely schematic views of preferred embodiments according to the invention. In the figures, the same reference numbers refer to equal or corresponding parts.

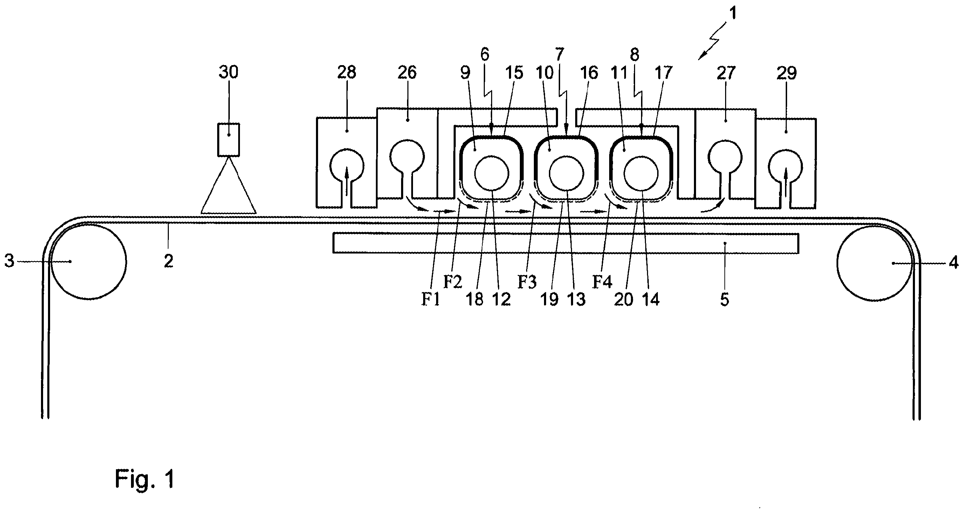

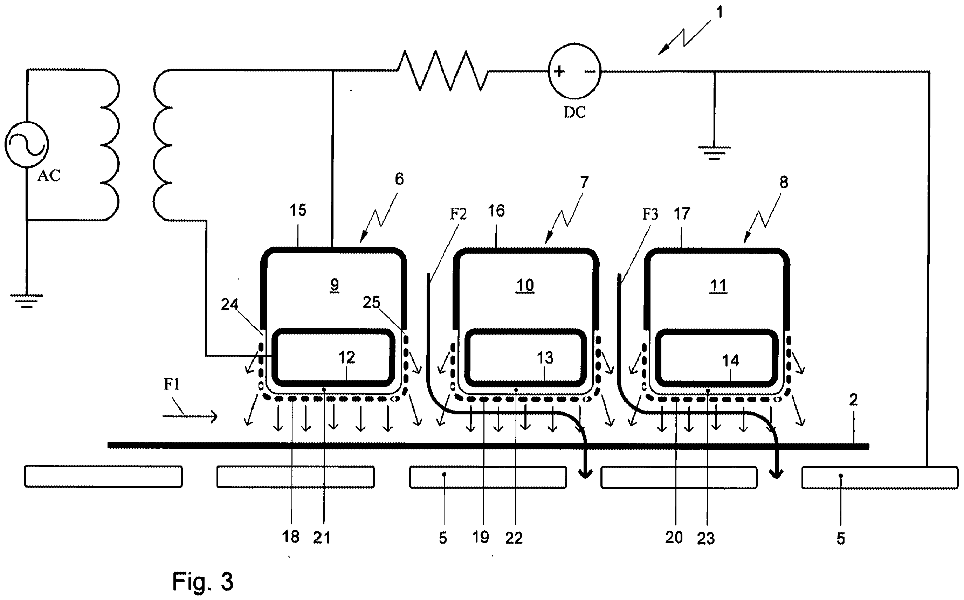

Figure 1 shows a schematic side view of a first embodiment of an apparatus 1 according to the invention. The apparatus 1 is arranged for treating an object using a plasma process. Thereto, the apparatus 1 comprises a supporting structure for supporting the object 2 and an electrode structure for generating the plasma process. The support structure comprises a number of rollers 3, 4 and a plate 5 that is gas permeable. The object 2 is formed by a substrate that is transported via the rollers 3, 4 along the plate 5. The electrode structure includes a series of surface dielectric barrier discharge plasma units 6, 7, 8, each comprising a solid dielectric structure 9, 10, 11 provided with an interior space wherein an interior electrode 12, 13, 14 is arranged. The solid dielectric structures substantially have an elongate shape having an exterior treating surface 21-23 facing the object 2 and having a pair of exterior side surfaces 24, 25 extending from the exterior treating surface 21, see in more detail e.g. Figure 3. Further, each of the surface dielectric barrier discharge plasma units 6, 7, 8 comprises a further electrode 15, 16, 17 for generating in concert with the corresponding interior electrode 12, 13, 14 a surface dielectric barrier discharge (SDBD) plasma. The further electrode 15, 16, 17 is arranged on top of the solid dielectric structure facing away from the object 2.

The apparatus 1 further comprises multiple gas flow paths F1-F4 for separately flowing materials towards the object 2. Downstream sections of at least two gas flow paths of the multiple gas flow paths F1-F4 substantially coincide, thereby allowing materials of the separate flow paths to mix. Preferably, the substantially coinciding downstream sections of the at least two gas flow paths are located near the object, so that a desired particle composition does not need travelling a long distance before reaching the object to be treated. As a result, an efficient treating process is obtained.

During operation of the plasma units 6, 7, 8 a voltage differential is applied between the interior electrode and the further electrode, thus generating a surface discharge, in Fig. 1 indicated by dots 18, 19, 20. In a first gas flow path F1 directed substantially parallel to the treating surface of the solid dielectric structure, substantially parallel to surface of the object 2 to be treated, a first material or a first group of materials is flown from a first material supply unit 26 towards the object 2. After passing the object 2, the first material or the first group of materials is received in a receiving unit 27. Similarly, in a second, third and fourth flow path F2-F4 directed substantially transverse with respect to the treating surface of the solid dielectric structure, substantially along a side surface of a plasma unit, a second material or a second group of materials is flown from a second material supply unit (not shown) towards the object 2. If the object 2 is gas permeable, the material can be withdrawn via the gas permeable plate 5, thereby providing stable and predictable gas flow paths. The apparatus 1 is further provided with gas sucking elements 28, 29 located at the front end and the back end of the plasma unit arrangement, in a transport direction of the object 2, thereby avoiding contamination of surrounding air with process gases F1-F4 and their plasma chemical reaction products, and vice versa. Optionally, the apparatus 1 is further provided with a spray unit 30 for spraying the object 2 before the application of the plasma process. Similarly, the apparatus can be arranged for spraying the object after application of a plasma process, or after a first plasma process and before a second plasma process.

It is noted that the apparatus shown in Figure 1 can also be implemented otherwise, e.g. with a supporting plate 5 that is not gas permeable or even using only rollers 3 and 4 as a supporting structure without a supporting plate 5.

During operation of the apparatus 1, the first gas flow F1 is directed in the space between the plasma units 6, 7, 8 and the object 2. As an example, the first material, in the first gas flow F1 comprises a polymer forming monomer. This polymer forming monomer may contain functional chemical groups such as halogen containing functional groups with an antimicrobial function. Also the second, third and fourth gas flows F2-F4 are directed towards the space between the plasma units 6, 7, 8 and the object 2. Preferably, the second material polymerizes slowly, indirectly or not at all under influence of a SDBD plasma. Further, the second material is preferably electropositive so that no negative ions are formed. As an example, the second material does not contain O₂.

In an advantageous way, the plasma process is mainly applied to material in a specific gas flow path section, upstream to the coinciding downstream section. More specifically, the plasma process is mainly applied to the material in the second, third and fourth flow paths F2-F4 that are oriented substantially transverse with respect to the treating surface 21 of the solid dielectric structure 9. As a result, in the second, third and fourth flow paths F2-F4, a reactive plasma species are formed, e.g. electrons, ions such as N₂⁺, or radicals such as N. By mixing the reactive plasma species with the material in the first flow path F1 in the coinciding downstream section, a high deposition rate of a high quality polymer coating with intended functionalities can be realized on the object 2. Factors that favourably improve the deposition are a short distance between the plasma and the object 2 and efficient gas transport through the plate 5.

Properties of functional chemical groups in the first flow path F1 are preserved because presence of particles in F1 in close vicinity to the SDBD plasma ionization region, near the SDBD electrodes is counteracted by the second flow path F2 particles. Though in spite of various electron depleting processes in the SDBD plasma downstream region, e.g. electron-ion recombination, negative ion formation, electrons may still be present in the reactive plasma species RPS in the second flow path F2 when reacting with material of the first flow path F1 and/or the object 2. However, the average energy of electrons and electron impact dissociation are strongly reduced. The plasma induced chemical reactions between the activated initiator gas in the second flow path F2 with remaining ions and radicals on the one hand and monomer gas in the first gas flow path F1 on the other hand are more selective than would be the case wherein particles of the first gas flow path F1 are in direct contact with the ionization region of the SDBD plasma.

Further, polymerization on the SDBD electrodes itself is counteracted since in principle merely particles of the second gas flow path F2 are allowed in the vicinity of the SDBD electrode surface. In addition, SDBD electrode temperature conditions, as may be controlled by liquid or gas flowing inside the interior electrodes, are inappropriate for polymerization.

Transport of solid/liquid particles in a gas towards the SDBD electrodes is counteracted by the presence of the thermophoretic force and by electro-hydraulic effects due to unipolar particle charging and the Coulomb force. In order to counteract deposition of particles on the SDBD electrodes, the SDBD electrode can be used to produce an excess of unipolar charged particles, averaged over time. Further, transport of particles towards the object is thus enhanced. Further, removal of initial coating or particles from the electrodes can e.g. be accomplished by plasma catalytic decomposition, using e.g. TiO₂, and (mixed) transition metal catalysts such as Cu/Cr-oxide, Cu/Mn-oxide, Fe/Mn-oxide which are suitable at SDBD electrode temperatures below 120 °C. In this context it is noted that the electrode structure according the invention can have a much higher temperature than an average gas temperature and/or substrate temperature. Further, removal of particles from the electrodes can be performed using plasma induced pressure waves having the frequency of the applied voltage.

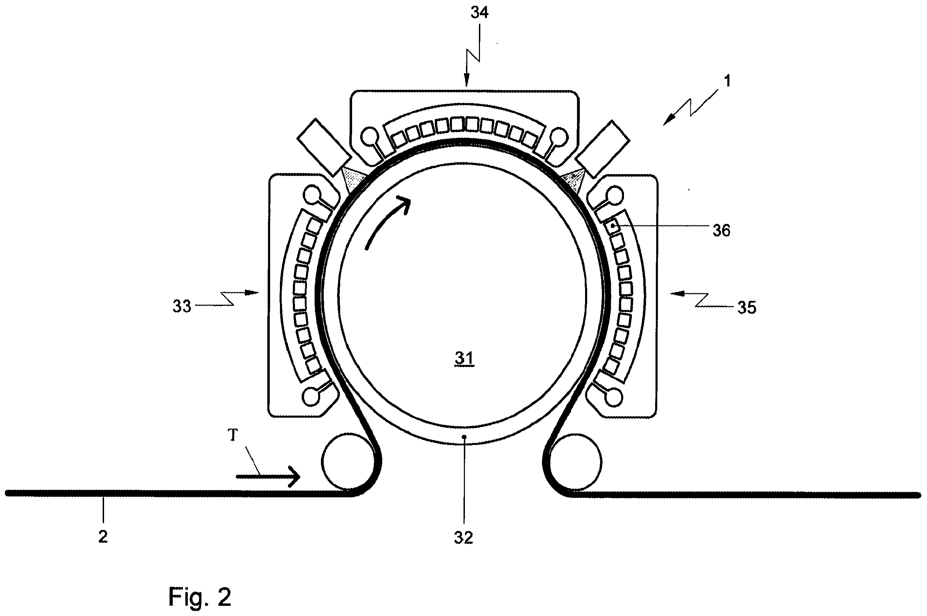

Fig. 2 shows a schematic side view of second embodiment of an apparatus 1 according to the invention. Here, the plasma unit arrangement is not planar but circular. More specifically, the support structure comprises a number of rollers 3, 4 and a top surface section 32 of a cylinder 31 that optionally is gas permeable. The object 2 or substrate is transported along the cylinder top surface section 32 in a transport direction T. Preferably, the cylinder 31 is rotating during operation. The apparatus comprises a multiple number of plasma unit series 33, 34, 35 each comprising a multiple number of plasma units 36.

Plasma treatment of the substrate 2 can e.g. be applied for surface activation or for plasma assisted coating and/or polymerization. In applying surface activation, functional groups on a polymer or other material surface are created. The surface energy is changed which is required for adhesion. Here, no coating is formed.

When applying a cylinder, a relatively high treatment speed can be obtained in combination with a large number of SDBD electrodes. Further, a reduced abrasion of substrate material is obtained, wherein a small slip velocity between substrate and cylinder is allowed for better gas distribution through gas permeable substrates. In addition, an easy and precise control of distance of a SDBD plasma unit to a substrate can be obtained. Preferably, the rotating cylinder is provided with openings such as slits and/or holes for gas transport and/or better control of residence time of reactive plasma species in gas permeable substrates. The rotating cylinder is preferably coated with an abrasion resistant layer, e.g. using a thermal spray coating process.

When using a cylinder, several plasma related functions can be integrated in a single system, assembled around the same rotating cylinder such as activation followed by graft-polymerization of a gaseous or liquid precursor, activation followed by plasma polymerization, activation followed by liquid spray followed by plasma polymerization, surface cleaning followed by activation followed by plasma polymerization, or cleaning of a first module during replacement by a second module (and vice versa). Cleaning of segments of the cylinder not covered by the substrate 2 can be achieved by a plasma method or another cleaning method (not drawn in Figure 2).

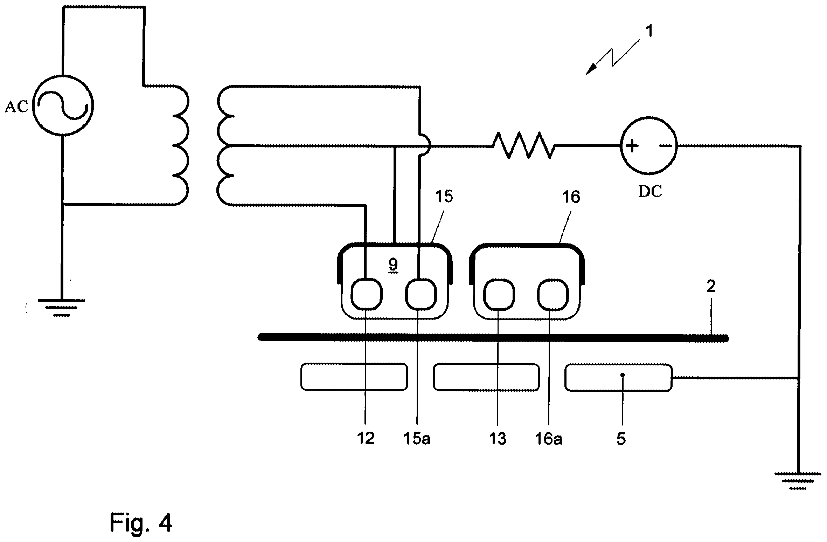

Figures 3 and 4 show a schematic side view of a third and a fourth embodiment, respectively, of an apparatus 1 according to the invention. Here, the electrode structure comprises an additional electrode for generating a time-averaged net electric field in the plasma region, i.e. the region where the plasma occurs. The gas permeable plate 5 that is earthed and connected to a DC source forms the third electrode. Hence, the time-averaged net electric field is directed, via the object, to the third electrode. As explicitly shown in Figures 3 and 4, an AC voltage differential is applied between the interior electrode 12 and the further electrode 15 partly covering the exterior of the dielectric body 9.

As indicated above referring to Figure 1, transport of solid/liquid particles from the gas flow path to the SDBD electrodes can be avoided or at least strongly reduced as a result of the so called electro-hydrodynamic force. The ions remaining on the SDBD treating surface as a result of each discharge, experience a Coulomb force as a result of the ion charge induced electric field being the electric field which is induced by the unipolar charge itself. The force has a component parallel to the dielectric surface as well as a component perpendicular to the dielectric surface. The electro-hydrodynamic force induces a gas flow by momentum transfer of ions to neutral gas, in the gas layer in very close vicinity of the SDBD treating surface.

An additional advantage of the electro-hydrodynamic behaviour is avoiding stagnancy of the gas in the thin gas layer close to the SDBD treating surface, the normal laminar flow. Thus, the electro-hydrodynamic force is used to enhance transport of undesirable solid particles away from the thin gas layer covering the SDBD treating surface.

The transport of a unipolar ion charge away from the SDBD electrodes, can be used to charge dust/particulate matter counteracting their deposition on the SDBD electrodes, e.g. via diffusion charging and/or field charging, thus without and with the presence of an additional electric field.

An additional time-averaged net electric field is applied which further enhances the transport of ions and charged dust/particulate matter to the substrate. This is e.g. achieved by application of an additional voltage source between the electrodes of the solid dielectric structures on the one hand, those electrodes will have a time-averaged zero or very low potential difference, and a conductive structure which is located at the opposite side of the substrate on the other hand. The conductive structure can e.g. be formed by the gas permeable plate 5 and can optionally be used for removing exhaust gasses and for transporting the substrate 2. In the particular case of a conductive substrate 2, the substrate may be used as the third electrode and the supporting structure 5 as not required to be conductive.

Figures 3 and 4 show possible electrical circuit to realize the additional static electric field. The circuits enable the superposition of an AC or repetitive pulsed voltage on a constant DC potential.

For understanding of the physical mechanisms of the proposed principle, it is noted that during each discharge event a reservoir of (alternating unipolar) ions are collected on the dielectric barrier. With the positive DC potential applied to the exterior electrode, negative charges, e.g. electrons which are eventually detached from negative ions, are removed while positive charges are concentrated on the electrode.

In the additional DC field, those positive charges will drift towards the earthed electrode. This is a slow process with a time -scale which is much longer than the period of time in between repetitive SDBD discharges. The constant applied electric field, applied in the space between the SDBD electrode and the ground electrode, is not used for ionization (plasma formation) but only for transport (electric field driven drift of ions) of a net (unipolar) space charge.

In the configuration shown in Figure 4, a SDBD plasma is generated as a result of the electric field caused by two isolated (dielectric covered) electrodes 12, 15a; 13, 16a and as a result of the electric field caused by the electric field of each of the interior electrodes and the exterior electrode 15, 16. The exterior electrode is set at a positive DC potential with respect to ground potential. An advantage of this configuration with respect to the configuration shown in Fig. 3 is that a larger surface parallel to the substrate 2 can be covered with SDBD plasma for the same level of applied voltage (with respect to ground potential).

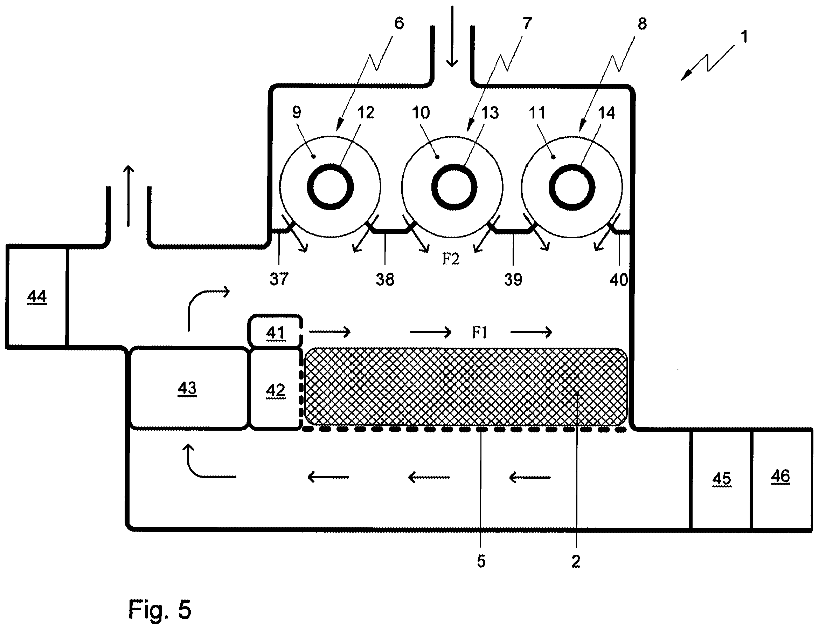

Figure 5 shows a schematic side view of a fifth embodiment of an apparatus 1 according to the invention. Here, the dielectric barrier discharge plasma units 6, 7, 8 have been constructed otherwise. The solid dielectric structure 9, 10, 11 is cylindrical shaped comprising the interior electrode 12, 13, 14. Strips 37, 38, 39, 40 contacting the exterior surface of the solid dielectric structure 9, 10, 11, form the further electrode. In a cross sectional view, the strips have a saw tooth end profile both contacting the solid dielectric structure and providing openings between the solid dielectric structure and the strips, thereby allowing gas from a second gas flow path F2 to pass the strips near the solid dielectric structure.

The apparatus in Fig. 5 comprises a perforated supporting structure 5 carrying an object 2 to be cleaned.

Generally, chemical components of oxidative cleaning agents in plasma processes are strongly electronegative. The addition of O₂ (formation of O and O₃), H₂O (OH, H₂O₂, HO₂), and/or halogen groups (Cl, Br, F) in plasma is accompanied with negative ion formation and thus strong depletion of the electron concentration occurs.

When using the apparatus according to the invention as shown in Figure 5, chemical cleaning agents can be included in a first gas flow F1, in combination with a SDBD plasma generated in a separate, second gas flow path F2. The use of a separate gas stream F2 in a SDBD plasma jet configuration offers the significant advantage of transporting reactive plasma species (ions, radicals, vibrational and electronic excited states) over a relatively long distance.

The SDBD electrode configuration comprises interior electrodes 12, 13, 14, optionally heated or cooled, and exterior electrodes 37-40 having a saw tooth edge. The gas flow path F2 is allowed to pass along the dielectric surface, in the open space which is left when a conductive saw tooth array is pressed against the dielectric surface. As a result, a very low excitation voltage is needed to create plasma and the gas is forced to pass exactly in the most active part of the SDBD plasma region.

Again, unipolar charging of SDBD plasma (e.g. net positive charging) can be used to counteract particle deposition on electrodes, to enhance particle transport away from the electrode. Further, when the object 2 serves as a filter material, application of a DC potential between a grid (below the object 2) and the SDBD electrode, or between a conductive filter material 2 and the SDBD electrode enhances particle collection on the filter material.

During operation of the apparatus, the object 2 can be cleaned. The object 2 is put in the reactor 'chamber', or various objects are put in a volume of the chamber, for example on a support structure 5 (conductive). Additives such as water, H₂O₂, halogen containing compounds, e.g. (existing) disinfectants, can be sprayed (liquid aerosol) via a first additive unit 41 or dispersed (as gas, liquid or powder) via second additive unit 42 so that the object 2 is covered by those additives. Plasma activated gas F2 is flown towards the surface and used for a chemical reaction of reactive plasma species with the gas F1 and/or the additives. As a result, oxidative radicals such as O, OH, Cl etc are produced at the location of the polluted surface resulting in very effective, efficient and fast cleaning.

The method may be used to disinfect or sterilize medical instruments, pharmaceutical packaging and skin of the hands and under arms. In the latter case, the arms can be inserted in the chamber via gas tight circular openings. The method may result in a significant reduction of the treatment time when compared to known liquid or gas cleaning methods.

The apparatus further comprises a pump 43 to re-circulate the gas containing disinfecting additives. The gas used for the plasma activated gas F2 may be split off from the re-circulated gas F1, but preferably dry air, pure nitrogen, or oxygen-nitrogen mixtures with reduced oxygen concentration are used. Economic solutions for oxygen reduction in air may be used, e.g. polymer based membrane separation or centrifugal methods.

A further application is the regeneration of air filters. The air filter system has an inlet valve 44 and outlet valve 45. The object 2 becomes saturated with particulate matter and adsorbed gasses. The object 2 is thus a combined or integrated filter based on materials such as glass fibre, activated carbon, reticulated carbon, zeolites, ceramic or polymer foam or other materials and combinations thereof.

The filter material is 'regenerated' meaning that a significant part of the filtered organic material is oxidized and removed, during a short period where valves 44 and 45 are closed. During regeneration, gas F1 is flown through the object 2, the filter material, and optionally additives are added via the first and/or second additive unit 41, 42.

After regeneration, the circulated gas may be catalytically cleaned using a catalyst unit 46.

During operation of the apparatus according to the invention, a distance between the object or substrate and the SDBD electrodes is needed to allow flowing of the first gas flow and to ensure transport of the second gas flow, generally transversely, to the first gas and surface of the object or substrate. In the majority of applications the above-mentioned distance is relatively small and well defined. In order to obtain such a relatively small and well defined distance, a flat SDBD electrode surface can advantageously be applied. Similarly, manufacturing techniques to obtain such a very flat SDBD electrode are advantageous as well.

Such manufacturing techniques include mechanical treatment, such as grinding, polishing etc, of the SDBD electrode surface, viz. the dielectric and/or metal materials, to obtain a very flat surface. Further, a number of solid dielectric barrier structures can be treated simultaneously to obtain a series of SDBD electrodes to form a common flat or 1-D curved SDBD treating plane. In addition, rectangular thin wall/small cross section elongated metal structures can be cooled during thermal deposition of the dielectric barrier coating. Cooling is possible via an opening inside the metal structure. Absence of cooling will generally result in significant thermal deformation of a rectangular shape during the thermal deposition process, resulting in a less quality structure of the coating and/or a less flat surface.

Preferably, the surface dielectric barrier discharge plasma unit has been manufactured using a thermal coating process, thereby providing a relatively cheap and reliable manufacturing process.

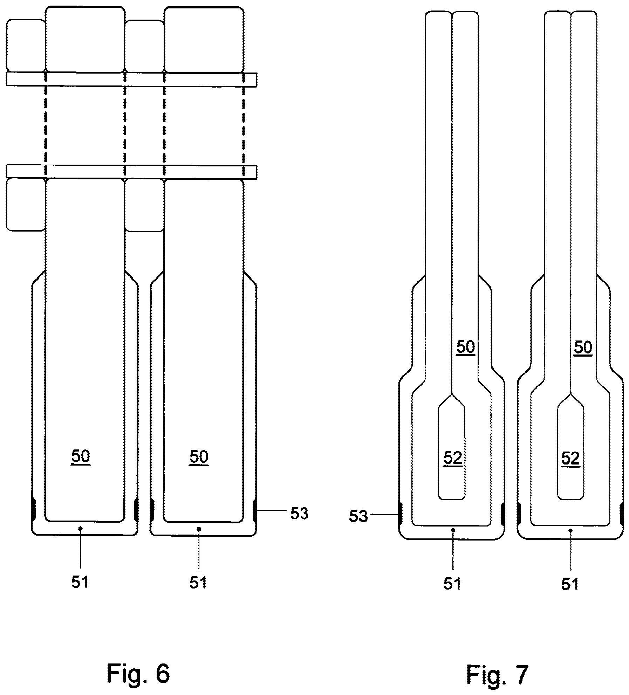

Figures 6-8 show a schematic view of a first, second and third embodiment, respectively, of a dielectric barrier discharge plasma unit used in the apparatus 1 shown in Figure 1.

A dielectric barrier discharge plasma unit can be manufactured using a thermal ceramic or glass dielectric deposition process on a metal base 50 having electrical conductive properties.

An exemplary electrode parallel to a treated surface has preferably a width of several mm, e.g. 3-5 mm, and a length of several meters, e.g. 3-5 meters.

Starting from a metal core 50, a thermal spray technique can be applied to deposit a ceramic layer 51, Al₂O₃, on top of the metal core 50. In this process, it is desired to cool the relatively very thin metal structure. This can be achieved by using a relatively high structure, thus exploiting a further dimension of the structure to form a strip or plate, see Fig. 6. As an example, the height may be chosen to be 20-40 mm. Only a part (e.g. ca. 50%) of the structure needs to be coated with dielectric.

Holes in the plate, which can be used to fix a cooling structure during the manufacturing process, can be used as well for fixation and temperature conditioning during application in a process.

Treatment of a deposited ceramic layer 51 is important. For example the deposited ceramic layer can be grinded to obtain a flat surface. The grinding procedure is preferably applied when the total number of electrodes is already fixed in a module, so as to obtain minimal differences in height of electrodes with respect to a substrate.

Additionally, after deposition of the ceramic layer, the layer may be further coated with a thin layer of a suspension of glass particles.

As an additional feature, catalyst particles may be included. This can be important for keeping the electrodes free from polymeric deposits during plasma assisted chemical vapour deposition, especially when a suitable dielectric barrier surface temperature is applied.

Subsequently, a thin metal strip 53 is deposited. The metal strip 53 is preferably positioned at the side surface of the structure so as to avoid abrasion and surface roughness.

The conductive base material can be obtained by several precision forming techniques of metal sheet such as bending, stamping, cutting and grinding. In this way an interior opening 52 for thermal conditioning can be easily obtained, see Fig. 7. The opening 52 can be used as a temperature conditioning channel to be applied during both manufacturing and final application.

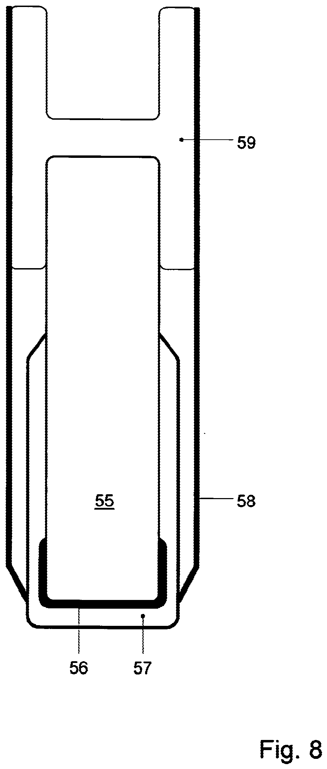

As an alternative, Fig. 8 shows a dielectric barrier discharge plasma unit that has been manufactured starting from an elongated, thin ceramic strip 55, optionally obtained by extrusion or cutting of a larger ceramic plate. This ceramic strip 55 is first coated, by thermal spray, with a thin metal electrode 56, then coated with a dielectric 57, again by thermal spray. An uncoated side of the ceramic strip is inserted in a metal H shaped supporting structure 59. This structure also supports external electrodes 58 with a saw teeth structure. Transverse gas injection is possible along the side surface of the (coated) ceramic strip, through the openings of the saw teeth. It is noted that a plasma region can be determined by choosing a specific local thickness of the dielectric material, i.e. parallel to the substrate or transversely to the substrate or both. The H shaped metal support structure 59 can be made of metal and used for fixation/cooling during manufacturing as well as in the final module assembly.

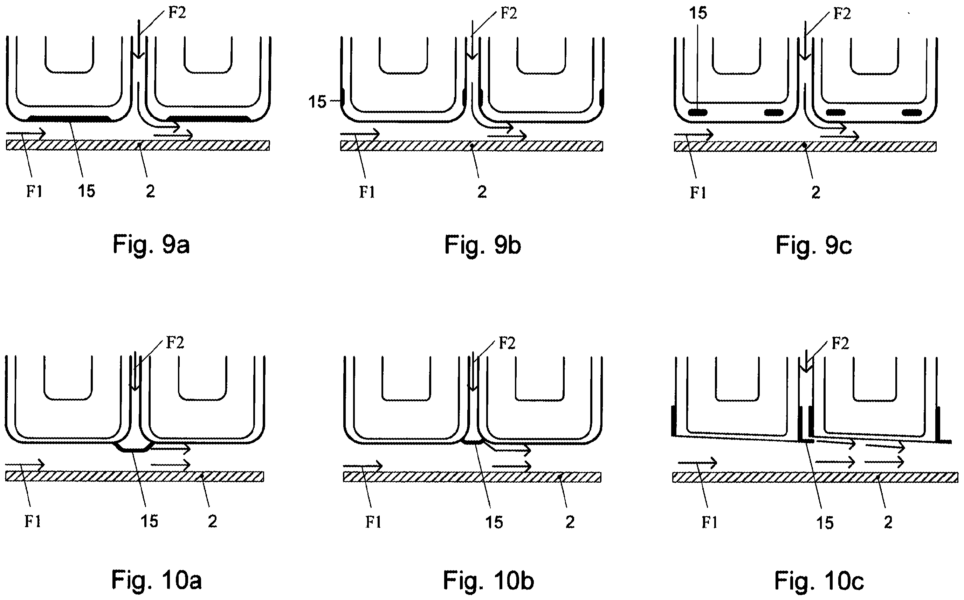

Figures 9a-c and Figures 10a-c show a schematic view of a first to sixth embodiment, respectively, of two dielectric barrier discharge plasma units used in the apparatus shown in Figure 1. In Figures 9a-c, the external electrode 15 of the units differ in location and form.

Thermal deposition, such as spray and other techniques, can be used to provide dielectric structure and second electrode on conductive base. Flat, polished structures can be obtained by means of masking during thermal deposition, grinding, polishing, and/or glass finishing techniques.

In Figures 10a-c, the exterior electrode 15 is not thermally deposited. A solid metal e.g. saw teeth structure is applied. Gas flow is forced to follow a path along the parallel part of the SDBD electrode.

Application of units shown in Figure 10a-c may be essential to some applications where other methods to avoid deposition on electrodes appear to be less effective.

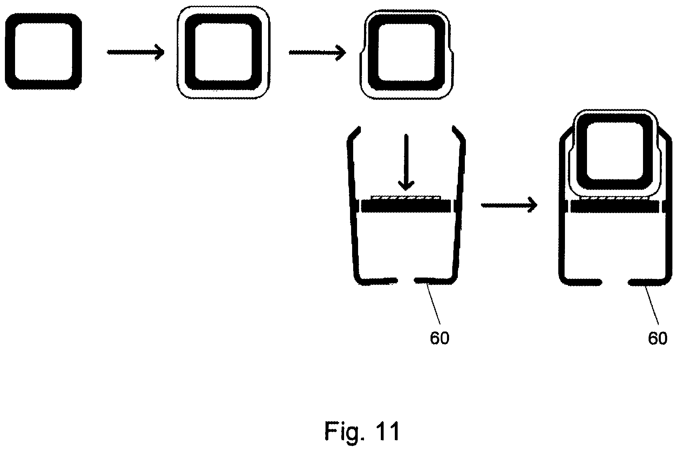

Fig. 11 shows a schematic view of a dielectric barrier discharge plasma unit manufacturing process wherein a thermal coating process is applied. Here, a clamp structure 60 is applied that also serves as an exterior electrode, having a saw tooth structure.

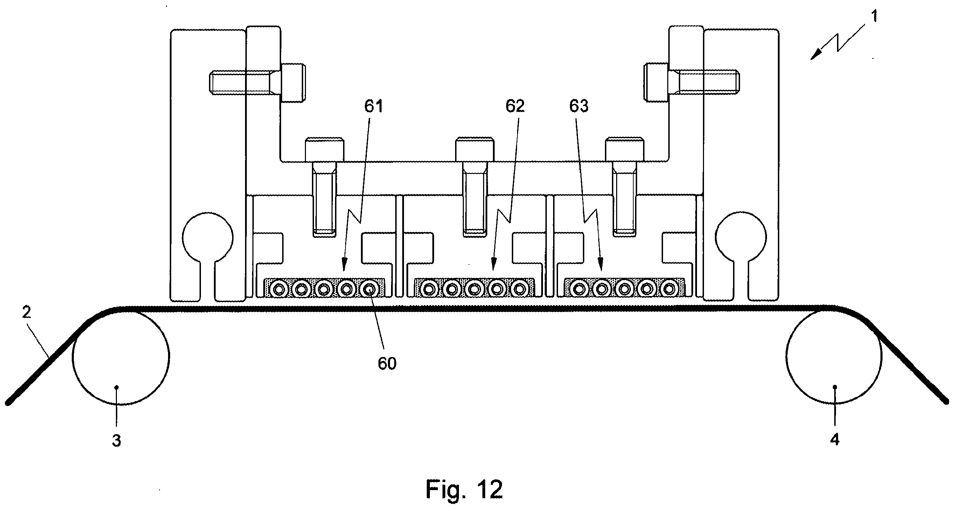

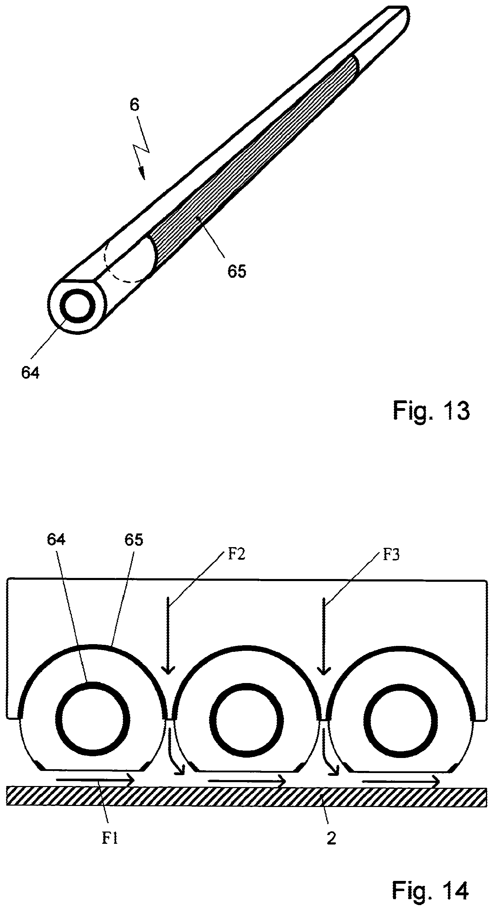

Figure 12 shows a schematic side view of sixth embodiment of an apparatus 1 according to the invention, the apparatus comprising three blocks of plasma unit arrays. Figure 13 shows a schematic view of a dielectric barrier discharge plasma unit 6 used in the apparatus 1 shown in Figure 12. The unit 6 comprises an extruded ceramic tube having a conductive coating 64 or conductive tube at the inside and a conductive coating 65 or partially cut conductive tube at the outside. The tubes can be fixed in a conductive epoxy paste. The whole assemble structure is grinded so as to obtain a smooth and perfectly flat surface. The conductive paste can be made very porous, e.g. foam structure using e.g. solvent evaporation techniques, so that gas can be injected.

Fig. 14 shows a schematic view of a series of dielectric barrier discharge plasma units used in the apparatus shown in Figure 12.

The apparatus according to the invention can in principle be applied to a variety of fields, e.g. for forming AM and multifunctional functions of nanoporous and/or hyperbranched polymer coatings, for protection against ballistic, stab, knife and/or puncture, and for cleaning, disinfection and/or sterilization functionality.

The invention is not restricted to the embodiments described herein.

As an example, various shapes of electrodes on the solid dielectric structure of the plasma units can be implemented.

Further, as an option, SDBD plasma treatment at two opposite sides of an object to be treated can be realized by implementing a similar arrangement of plasma units on the opposite side of the object.

Advantageously, the cylinder shown in Figure 2 can be provided with a separate cleaning unit for cleaning the top surface of the cylinder.

Further such variants will be obvious for the man skilled in the art and are considered to lie within the scope of the invention as formulated in the following claims.

## Claims

1. Apparatus (1) for treating an object (2) using a plasma process, comprising
- a supporting structure (3, 4, 5) for supporting the object,
- an electrode structure for generating the plasma process, including a surface dielectric barrier discharge plasma unit (6, 7, 8) comprising a solid dielectric structure (9, 10, 11) provided with an interior space wherein an interior electrode (12, 13, 14) is arranged, further comprising a further electrode (15, 16, 17) for generating in concert with the interior electrode a surface dielectric barrier discharge plasma,
wherein the apparatus further comprises multiple gas flow paths (F1, F2, F3, F4) configured to separately flowing materials towards the object and **characterised in that** downstream sections of at least two gas flow paths of the multiple gas flow paths substantially coincide, wherein a gas in the first of the two gas flow paths contains a first material and wherein a gas in the second of the two gas flow paths contains a second material, and wherein the substantially coinciding downstream sections of the at least two gas flow paths are located near the object.

2. Apparatus according to claim 1, wherein the first material includes a disinfectant.

3. Apparatus according to claim 1 or 2, wherein the further electrode is a solid metal having a saw teeth structure arranged to force a gas to follow a path along an exterior side surface of the solid dielectric structure (9, 10, 11).

4. Apparatus according to any of the preceding claims, wherein the solid dielectric structure substantially has an elongate shape having an exterior treating surface facing the object and having the exterior side surface extending from the exterior treating surface.

5. Apparatus according to claim 4, wherein at least one gas flow path is oriented substantially transverse with respect to the treating surface of the solid dielectric structure, and/or wherein at least one gas flow path is oriented substantially along the exterior side surface of the solid dielectric structure.

6. Apparatus according to any of the previous claims 4-5, wherein a gas flow path is oriented substantially parallel to the treating surface of the solid dielectric structure.

7. Apparatus according to any of the previous claims, wherein the surface dielectric barrier discharge plasma unit has been manufactured using a thermal coating process.

8. Apparatus according to any of the previous claims, wherein the solid dielectric structure has been coated with a thin layer of a suspension of glass particles and/or include catalyst particles.

9. Apparatus according to any of the previous claims, wherein the electrode structure comprises an additional electrode for generating a time-averaged net electric field in the plasma region.

10. Apparatus according to any of the previous claims, wherein the supporting structure comprises a plate having a gas permeable structure.

11. Apparatus according to any of the previous claims, further comprising a spray unit for spraying the object before the application of the plasma process.

12. Apparatus according to any of the previous claims, wherein the supporting structure comprises a top surface section of a cylinder.

13. A method for treating an object using a plasma process, comprising the steps of:
- supporting the object, and
- applying a potential difference between electrodes of an electrode structure to generate the plasma process, using an apparatus comprising a surface dielectric barrier discharge plasma unit comprising a solid dielectric structure provided with an interior space wherein an interior electrode is arranged, further comprising a further electrode for generating in concert with the interior electrode a surface dielectric barrier discharge plasma further comprising separately flowing materials towards the object via multiple gas flow paths wherein downstream sections of at least two gas flow paths of the multiple gas flow paths substantially coincide, wherein a gas in the first of the two gas flow paths contains a first material and wherein a gas in the second of the two gas flow paths contains a second material, wherein the substantially coinciding downstream sections of the at least two gas flow paths are located near the object.

14. A method according to claim 13, wherein the plasma process is mainly applied to material in a specific gas flow path section, upstream to a coinciding downstream section.

15. A method according to claim 13 or 14, wherein the first material includes a disinfectant.

## Patentansprüche

1. Vorrichtung (1) zur Behandlung eines Objekts (2) unter Verwendung eines Plasmaverfahrens, umfassend:
- eine Trägerstruktur (3, 4, 5) zum Trägern des Objekts,
- eine Elektrodenstruktur zum Erzeugen des Plasmaverfahrens, umfassend eine dielektrische Oberflächenbarriereentladungs-Plasmaeinheit (6, 7, 8), umfassend eine feste dielektrische Struktur (9, 10, 11), versehen mit einem Innenraum, in dem eine innere Elektrode (12, 13, 14) angeordnet ist, ferner umfassend eine weitere Elektrode (15, 16, 17), um in Übereinstimmung mit der inneren Elektrode ein dielektrisches Oberflächenbarriereentladungs-Plasma zu erzeugen,
wobei die Vorrichtung ferner mehrere Gasströmungswege (F1, F2, F3, F4) umfasst, konfiguriert um getrennt Materialien zu dem Objekt zu strömen, und **dadurch gekennzeichnet, dass** Stromabwärtsabschnitte von mindestens zwei Gasströmungswegen der mehreren Gasströmungswege zusammentreffen, wobei ein Gas in dem ersten der zwei Gasströmungswege ein erstes Material enthält und wobei ein Gas in dem zweiten der zwei Gasströmungswege ein zweites Material enthält, und wobei die im Wesentlichen zusammentreffenden Stromabwärtsabschnitte der mindestens zwei Gasströmungswege sich nahe bei dem Objekt befinden.

2. Vorrichtung nach Anspruch 1, wobei das erste Material ein Desinfektionsmittel umfasst.

3. Vorrichtung nach Anspruch 1 oder 2, wobei die weitere Elektrode ein festes Metall mit einer Sägezahnstruktur ist, angeordnet, um ein Gas zu zwingen, einem Weg entlang der äußeren Seitenoberfläche der festen dielektrischen Struktur (9, 10, 11) zu folgen.

4. Vorrichtung nach einem der vorhergehenden Ansprüche, wobei die feste dielektrische Struktur im Wesentlichen eine längliche Form mit einer äußeren, zu dem Objekt gerichteten Behandlungsoberfläche hat, und mit der äußeren Seitenoberfläche verlaufend von der äußeren Behandlungsoberfläche.

5. Vorrichtung nach Anspruch 4, wobei mindestens ein Gasströmungsweg im Wesentlichen quer in Bezug auf die Behandlungsoberfläche der festen dielektrischen Struktur ausgerichtet ist und/oder wobei mindestens ein Gasströmungsweg im Wesentlichen entlang der äußeren Seitenoberfläche der festen dielektrischen Struktur ausgerichtet ist.

6. Vorrichtung nach einem der vorhergehenden Ansprüche 4-5, wobei ein Gasströmungsweg im Wesentlichen parallel zu der Behandlungsoberfläche der festen dielektrischen Struktur ausgerichtet ist.

7. Vorrichtung nach einem der vorhergehenden Ansprüche, wobei die Plasmaeinheit für dielektrisch behinderte Oberflächenentladung unter Verwendung eines Wärmebeschichtungsverfahrens hergestellt wurde.

8. Verfahren nach einem der vorhergehenden Ansprüche, wobei die feste dielektrische Struktur mit einer dünnen Schicht einer Suspension aus Glaspartikeln und/oder eingeschlossenen Katalysatorpartikeln beschichtet wurde.

9. Vorrichtung nach einem der vorhergehenden Ansprüche, wobei die Elektrodenstruktur eine zusätzliche Elektrode zum Erzeugen eines zeitlich gemittelten elektrischen Nettofeldes in der Plasmaregion umfasst.

10. Vorrichtung nach einem der vorhergehenden Ansprüche, wobei die Trägerstruktur eine Platte mit einer gasdurchlässigen Struktur umfasst.

11. Vorrichtung nach einem der vorhergehenden Ansprüche, ferner umfassend eine Sprüheinheit zum Besprühen des Objekts vor der Anwendung des Plasmaverfahrens.

12. Vorrichtung nach einem der vorhergehenden Ansprüche, wobei die Trägerstruktur einen oberen Oberflächenabschnitt eines Zylinders umfasst.

13. Verfahren zur Behandlung eines Objekts unter Verwendung eines Plasmaverfahrens, umfassend folgende Schritte:
- Trägern des Objekts und
- Anwenden einer potenziellen Differenz zwischen Elektroden einer Elektrodenstruktur zum Erzeugen des Plasmaverfahrens, unter Verwendung einer Vorrichtung, umfassend eine Plasmaeinheit zur dielektrisch behinderten Oberflächenentladung, umfassend eine feste dielektrische Struktur, versehen mit einem Innenraum, in dem eine innere Elektrode angeordnet ist, ferner umfassend eine weitere Elektrode, um in Übereinstimmung mit der inneren Elektrode ein dielektrisches Oberflächenbarriereentladungs-Plasma zu erzeugen, ferner umfassend getrennt strömende Materialien zu dem Objekt über mehrere Gasströmungswege, wobei Stromabwärtsabschnitte von mindestens zwei Gasströmungswegen der mehreren Gasströmungswege im Wesentlichen zusammentreffen, wobei ein Gas in dem ersten der zwei Gasströmungswege ein erstes Material enthält und wobei ein Gas in dem zweiten der zwei Gasströmungswege ein zweites Material enthält, wobei die im Wesentlichen zusammentreffenden Stromabwärtsabschnitte der mindestens zwei Gasströmungswege sich nahe bei dem Objekt befinden.

14. Verfahren nach Anspruch 13, wobei das Plasmaverfahren hauptsächlich auf Material in einem bestimmten Gasströmungswegabschnitt stromabwärts von einem zusammentreffenden Stromabwärtsabschnitt angewendet wird.

15. Verfahren nach Anspruch 13 oder 14, wobei das erste Material ein Desinfektionsmittel umfasst.

## Revendications

1. Appareil (1) pour traiter un objet (2) utilisant un traitement au plasma, comprenant
- une structure de support (3, 4, 5) pour supporter l'objet,
- une structure d'électrode pour générer le traitement au plasma, incluant une unité de plasma de décharge à barrière diélectrique de surface (6, 7, 8) comprenant une structure diélectrique solide (9, 10, 11) pourvue d'un espace intérieur dans lequel est agencée une électrode intérieure (12, 13, 14), comprenant en outre une autre électrode (15, 16, 17) pour générer de concert avec l'électrode intérieure un plasma de décharge à barrière diélectrique de surface,
dans lequel l'appareil comprend en outre de multiples trajets d'écoulement de gaz (F1, F2, F3, F4) configurés pour assurer l'écoulement séparé de substances vers l'objet et **caractérisé en ce que** les sections en aval d'au moins deux trajets d'écoulement de gaz des multiples trajets d'écoulement de gaz coïncident sensiblement, dans lequel un gaz dans le premier des deux trajets d'écoulement de gaz contient une première substance et dans lequel un gaz dans le second des deux trajets d'écoulement de gaz contient une seconde substance, et dans lequel les sections en aval coïncidant sensiblement des au moins deux trajets d'écoulement de gaz se trouvent à proximité de l'objet.

2. Appareil selon la revendication 1, dans lequel la première substance inclut un désinfectant.

3. Appareil selon la revendication 1 ou 2, dans lequel l'autre électrode est un métal solide ayant une structure en dents de scie agencée pour forcer un gaz à suivre un trajet le long d'une surface latérale extérieure de la structure diélectrique solide (9, 10, 11).

4. Appareil selon l'une quelconque des revendications précédentes, dans lequel la structure diélectrique solide a sensiblement une forme allongée ayant une surface de traitement extérieure faisant face à l'objet et ayant la surface latérale extérieure s'étendant à partir de la surface de traitement extérieure.

5. Appareil selon la revendication 4, dans lequel au moins un trajet d'écoulement de gaz est orienté sensiblement transversalement par rapport à la surface de traitement de la structure diélectrique solide, et/ou dans lequel au moins un trajet d'écoulement de gaz est orienté sensiblement le long de la surface latérale extérieure de la structure diélectrique solide.

6. Appareil selon l'une quelconque des revendications 4 et 5 précédentes, dans lequel un trajet d'écoulement de gaz est orienté sensiblement parallèlement à la surface de traitement de la structure diélectrique solide.

7. Appareil selon l'une quelconque des revendications précédentes, dans lequel l'unité de plasma de décharge à barrière diélectrique de surface a été fabriquée au moyen d'un procédé de revêtement thermique.

8. Appareil selon l'une quelconque des revendications précédentes, dans lequel la structure diélectrique solide a été revêtue avec une couche mince d'une suspension de particules de verre et/ou inclut des particules de catalyseur.

9. Appareil selon l'une quelconque des revendications précédentes, dans lequel la structure d'électrode comprend une électrode supplémentaire pour générer un champ électrique net moyenné dans le temps dans la région de plasma.

10. Appareil selon l'une quelconque des revendications précédentes, dans lequel la structure de support comprend une plaque ayant une structure perméable au gaz.

11. Appareil selon l'une quelconque des revendications précédentes, comprenant en outre une unité de pulvérisation pour pulvériser l'objet avant l'application du traitement au plasma.

12. Appareil selon l'une quelconque des revendications précédentes, dans lequel la structure de support comprend une section de surface supérieure d'un cylindre.

13. Procédé pour traiter un objet au moyen d'un traitement au plasma, comprenant les étapes de :
- maintien de l'objet, et
- application d'une différence de potentiel entre électrodes d'une structure d'électrode pour générer le traitement au plasma, au moyen d'un appareil comprenant une unité de plasma de décharge à barrière diélectrique de surface comprenant une structure diélectrique solide pourvue d'un espace intérieur dans lequel est agencée une électrode intérieure, comprenant en outre une autre électrode pour générer de concert avec l'électrode intérieure un plasma de décharge à barrière diélectrique de surface comprenant des substances s'écoulant séparément vers l'objet via de multiples trajets d'écoulement de gaz, dans lequel les sections en aval d'au moins deux trajets d'écoulement de gaz des multiples trajets d'écoulement de gaz coïncident sensiblement, dans lequel un gaz dans le premier des deux trajets d'écoulement de gaz contient une première substance et dans lequel un gaz dans le second des deux trajets d'écoulement de gaz contient une seconde substance, dans lequel les sections en aval coïncidant sensiblement des au moins deux trajets d'écoulement de gaz se trouvent à proximité de l'objet.

14. Procédé selon la revendication 13, dans lequel le traitement au plasma est principalement appliqué à une substance dans une section de trajet d'écoulement de gaz spécifique, en amont d'une section coïncidant en aval.

15. Procédé selon la revendication 13 ou 14, dans lequel la première substance inclut un désinfectant.
